# EUROPEAN PATENT APPLICATION

(11) **EP 4 786 633 A1**
(43) Date of publication of application: **05.08.2026**
(21) Application number: 24887760.7
(22) Date of filing: 24.10.2024
(51) Int. Cl.: C23C 14/35

(54) **AUXILIARY TEMPERATURE-CONTROL DEVICE FOR SEMICONDUCTOR PROCESS CHAMBER, AND SEMICONDUCTOR PROCESS CHAMBER**

(30) Priority: 06.11.2023 CN 202311466069
(71) Applicant: Beijing NAURA Microelectronics Equipment Co., Ltd., Beijing 100176 (CN)
(72) Inventor: PEI, Lixin, Beijing 100176 (CN); HUANG, Qiwei, Beijing 100176 (CN); ZHANG, Qingshan, Beijing 100176 (CN); ZHANG, Xianpeng, Beijing 100176 (CN); GU, Qiang, Beijing 100176 (CN); LIU, Haowen, Beijing 100176 (CN); SONG, Jian, Beijing 100176 (CN); MENG, Lingyun, Beijing 100176 (CN); LIU, Xing, Beijing 100176 (CN)
(74) Representative: Cohausz & Florack
(86) International application number: PCT/CN2024/126963
(87) International publication number: WO 2025/098147

(57) **Abstract**

The present disclosure provides an auxiliary temperature-control device for a semiconductor process chamber and a semiconductor process chamber. The auxiliary temperature-control device includes a heat conduction assembly, which is configured to be fixedly connected to the semiconductor process chamber for heat exchange with a process kit in the semiconductor process chamber; a cooling channel, which is disposed in the heat conduction assembly, and is configured to introduce a cooling fluid to cool the heat conduction assembly; and a heating assembly, which is disposed in the heat conduction assembly, and is configured to heat the heat conduction assembly. In the auxiliary temperature-control device provided herein, by providing the heat conduction assembly and disposing the cooling channel and the heating assembly in the heat conduction assembly, a temperature of the heat conduction assembly can be adjusted with the cooling channel and the heating assembly, and heat exchange can be performed between the heat conduction assembly and the process kit to adjust a temperature of the process kit, so that the temperature of the process kit can be prevented from being too high or too low to affect wafers, which can improve wafer product quality.

## Description

### TECHNICAL FIELD

The present disclosure relates to the field of semiconductor manufacturing, and in particular, to an auxiliary temperature-control device for a semiconductor process chamber, and a semiconductor process chamber.

### BACKGROUND

As a type of metal/non-metal film formation technology widely used in the semiconductor industry, the Physical Vapor Deposition (PVD) technology has great application potential in the industry. According to the PVD technology, a process gas is introduced into a process chamber, a large potential difference is generated in the process chamber, the process gas is ionized into plasma under the action of the potential difference, a generated magnetic field is controlled to enable the plasma to bombard a target, and sputtered target atoms are deposited on a surface of a wafer to form a target film.

However, the process chamber in the existing technology has a poor temperature control capability for a peripheral region of the wafer, and a temperature of the wafer cannot reach the standard during the process, resulting in poor quality of the wafer.

### SUMMARY

The present disclosure aims to at least solve the problem of poor wafer quality in the existing technology caused by the fact that a temperature of a wafer cannot reach the standard during a process due to poor temperature control capability of the process chamber for a process region, and provides an auxiliary temperature-control device for a semiconductor process chamber and a semiconductor process chamber.

In order to achieve the objective of the present disclosure, there is provided an auxiliary temperature-control device for a semiconductor process chamber, including a heat conduction assembly, which is configured to be fixedly connected to the semiconductor process chamber for heat exchange with a process kit in the semiconductor process chamber; a cooling channel, which is disposed in the heat conduction assembly, and is configured to introduce a cooling fluid to cool the heat conduction assembly; and a heating assembly, which is disposed in the heat conduction assembly, and is configured to heat the heat conduction assembly.

In some embodiments, the heat conduction assembly includes:
a first heat conducting member, which is configured to be connected to a carrier of the semiconductor process chamber for heat exchange with a deposition ring of the process kit;
the cooling channel includes:
   a first cooling channel, which is disposed in the first heat conducting member; and
   the heating assembly includes:
      a first heating element, which is disposed in the first heat conducting member.

In some embodiments, the heat conduction assembly includes:
a second heat conducting member, which is configured to be connected to an inner wall of a chamber body of the semiconductor process chamber for heat exchange with a liner assembly of the process kit;
the cooling channel includes:
   a second cooling channel, which is disposed in the second heat conducting member; and
   the heating assembly includes:
      a second heating element, which is disposed in the second heat conducting member.

In some embodiments, the first heat conducting member includes:
a first heat exchange portion, which has a first heat exchange surface for attachment to the deposition ring; and
a first connecting portion, which is connected on an inner circumferential side of the first heat exchange portion, and is configured to be connected to the carrier.

In some embodiments, the first heat exchange portion is provided with a first annular protrusion and a first annular groove, the first annular protrusion is located on an outer circumferential side of the first heat exchange surface, the first annular groove is located between the first heat exchange surface and the first annular protrusion, and the first annular protrusion and the first annular groove are used for clearance fit with the liner assembly of the semiconductor process chamber to form a labyrinth passage.

In some embodiments, the second heat conducting member is provided with a second heat exchange portion and a second connecting portion, the second heat exchange portion has a second heat exchange surface for attachment to the liner assembly, and the second connecting portion is connected to an outer circumferential side of the second heat exchange portion, and is configured to be connected to the inner wall of the chamber body.

In some embodiments, the auxiliary temperature-control device further includes:
a first conductive member, which is configured to be respectively electrically connected to the first heat conducting member and the carrier.

In some embodiments, the auxiliary temperature-control device further includes:
a second conductive member, which is configured to be respectively electrically connected to the second heat conducting member and the liner assembly.

In some embodiments, the auxiliary temperature-control device further includes a connecting wire,
wherein the connecting wire is respectively electrically connected to the first heat conducting member and the second heat conducting member, and the second heat conducting member is further configured to be electrically connected to the inner wall of the chamber body to enable electrical conduction of the carrier, the first heat conducting member, the second heat conducting member, the liner assembly, and the inner wall of the chamber body.

In some embodiments, the auxiliary temperature-control device further includes:
a temperature measurement assembly, which is disposed on the heat conduction assembly to detect a temperature of the process kit.

In a second aspect of the present disclosure, there is provided a semiconductor process chamber, including a chamber body; a carrier and a process kit, which are disposed in the chamber body; and the above auxiliary temperature-control device, the auxiliary temperature-control device being fixedly connected to at least one of the chamber body and/or the carrier to adjust a temperature of the process kit.

In some embodiments, the process kit includes a liner assembly and a deposition ring, the liner assembly being connected to the chamber body, and the deposition ring being disposed around the carrier; and the auxiliary temperature-control device includes a first heat conducting member and/or a second heat conducting member, and the first heat conducting member is connected to the carrier, and is attached to the deposition ring; and the second heat conducting member is connected to an inner wall of the chamber body, and is attached to the liner assembly.

In some embodiments, the deposition ring is provided with an annular fitting portion at an outer circumferential side of the deposition ring, the fitting portion extends outwards to an outer side of the carrier, and the first heat conducting member is attached to the fitting portion.

In some embodiments, the liner assembly includes a sidewall portion, which is disposed along a direction perpendicular to a carrying surface of the carrier; and
a bottom wall portion, which is connected to the sidewall portion, and is disposed along a direction parallel to the carrying surface, the second heat conducting member being attached to the bottom wall portion.

In some embodiments, the deposition ring is provided with a fitting portion at an outer circumferential side of the deposition ring, the fitting portion extends outwards to an outer side of the carrier, and the fitting portion has a first side facing the carrying surface and a second side away from the carrying surface; and
the fitting portion has an annular inclined surface on the first side of the fitting portion, and a height of the annular inclined surface gradually increases in a direction from the inside to the outside of the deposition ring; and
the liner assembly further includes:
   a shielding portion, which is connected to an inner peripheral wall of the bottom wall portion, and is located above the annular inclined surface.

In some embodiments, a first passage is formed between an inner surface of the shielding portion facing the annular inclined surface and the annular inclined surface; a second passage communicating with the first passage is formed between the inner peripheral wall of the bottom wall portion and an outer peripheral wall of the fitting portion; and the first passage and the second passage form a part of a labyrinth passage together.

The present disclosure has the following beneficial effects.

In the auxiliary temperature-control device provided herein, by providing the heat conduction assembly and disposing the cooling channel and the heating assembly in the heat conduction assembly, a temperature of the heat conduction assembly can be adjusted with the cooling channel and the heating assembly, and heat exchange can be performed between the heat conduction assembly and the process kit to adjust a temperature of the process kit, so that the temperature of the process kit can be prevented from being too high or too low to affect wafers, which can improve wafer product quality.

In the semiconductor process chamber provided herein, by adopting the above auxiliary temperature-control device, a temperature of the process kit can be prevented from being too high or too low to affect wafers, which can improve wafer product quality.

### BRIEF DESCRIPTION OF DRAWINGS

FIG. 1 is a schematic structural diagram of a semiconductor process chamber in the existing technology;
FIG. 2 is a schematic diagram illustrating heat transfer directions in a semiconductor process chamber in the existing technology;
FIG. 3 is a schematic structural diagram of a first heat conducting member of an auxiliary temperature-control device according to an embodiment of the present disclosure;
FIG. 4 is a schematic structural diagram of a second heat conducting member of an auxiliary temperature-control device according to an embodiment of the present disclosure;
FIG. 5 is a schematic diagram illustrating application of an auxiliary temperature-control device to a semiconductor process chamber according to an embodiment of the present disclosure;
FIG. 6 is a partial enlarged view of a portion A in FIG. 5;
FIG. 7 is a partial enlarged view of a portion B in FIG. 6;
FIG. 8 is a schematic diagram illustrating heat transfer directions of a semiconductor process chamber in a high-power sputtering process according to an embodiment of the present disclosure; and
FIG. 9 is a schematic diagram illustrating heat transfer directions of a semiconductor process chamber in a low-power sputtering process according to an embodiment of the present disclosure;

List of reference numerals:
10-heat conduction assembly; 20-cooling channel; 30-heating assembly; 50-carrier; 51-ceramic portion; 52-metal portion; 60-deposition ring; 61-fitting portion; 611-annular inclined surface; 612-second annular protrusion; 62-main body; 70-liner assembly; 71-sidewall portion; 72-bottom wall portion; 721-second annular groove; 73-shielding portion; 80-chamber body; 81-upper chamber; 82-lower chamber; 90-labyrinth passage; 91-first passage; 92-second passage; 93-third passage; 110-coolant pipe; 120-annular step structure;
10a-first heat conducting member; 11a-first heat exchange portion; 111a-first heat exchange surface; 112a-first annular protrusion; 113a-first annular groove; 12a-first connecting portion; 20a-first cooling channel; 30a-first heating element; 40a-first conductive member; 100a-first temperature measuring member;
10b-second heat conducting member; 11b-second heat exchange portion; 111b-second heat exchange surface; 12b-second connecting portion; 20b-second cooling channel; 30b-second heating member; 40b-second conductive member; 100b-second temperature measuring member.

### DETAIL DESCRIPTION OF EMBODIMENTS

In order to enable those of ordinary skill in the art to better understand the technical solutions of the present disclosure, an auxiliary temperature-control device for a semiconductor process chamber and a semiconductor process chamber provided in the present disclosure are further described in detail below with reference to the drawings.

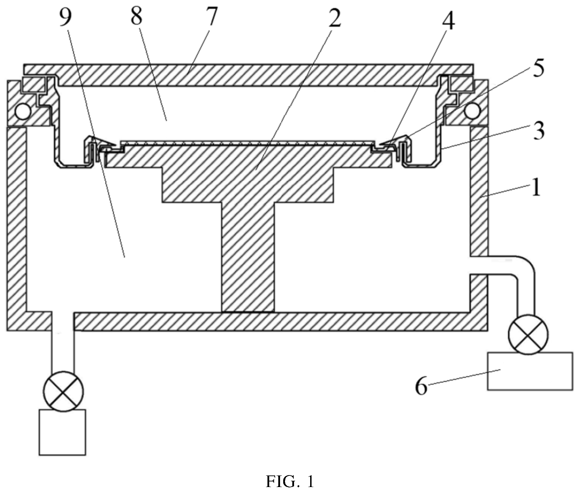

In the related technology, a process chamber for semiconductor processing as shown in FIG. 1 includes a chamber body 1, a carrier 2 disposed in the chamber body 1, and a process kit including a liner assembly 3, a deposition ring 4, and a shielding ring 5. A gas source 6 in FIG. 1 is configured to deliver a process gas into the chamber body 1. A target 7 is disposed at a top of the chamber body 1; and the liner assembly 3 is located on an outer peripheral side of the carrier 2; and the carrier 2 is used for placement of a wafer, the deposition ring 4 is disposed between the carrier 2 and the liner assembly 3, the carrier 2, the deposition ring 4, the liner assembly 3, and the target 7 divide an interior of the chamber body 1 into a process area 8 and a non-process area 9, the process area 8 is where a semiconductor process is performed, and the gas source 6 communicates with the non-process area 9.

The process chamber in the related technology has the following problems.

Firstly, in a high-power (22 KW-55 KW) sputtering process of an aluminum film and other types of films, the carrier 2 needs to move upwards and drive the deposition ring 4 to move upwards together, the deposition ring 4 contacts the shielding ring 5 after reaching a certain height, and the deposition ring 4 continues to move upwards, and drives the shielding ring 5 to move upwards to be separated from the liner assembly 3, thereby forming a flow gap. After entering the non-process area 9, the gas delivered by the gas source 6 enters the process area 8 through the flow gap for a plasma sputtering process.

The gas is excited into plasma after entering the process area 8, the plasma bombards the target 7 under the constraint of a magnetic field, and sputtered target atoms are deposited on a surface of a wafer to form a target film. Part of the sputtered target atoms which fall on the wafer to form the film is regarded as an effective sputtering part, and part of the sputtered target atoms which fall on the liner assembly 3, the shielding ring 5, and the deposition ring 4 is regarded as an ineffective sputtering part.

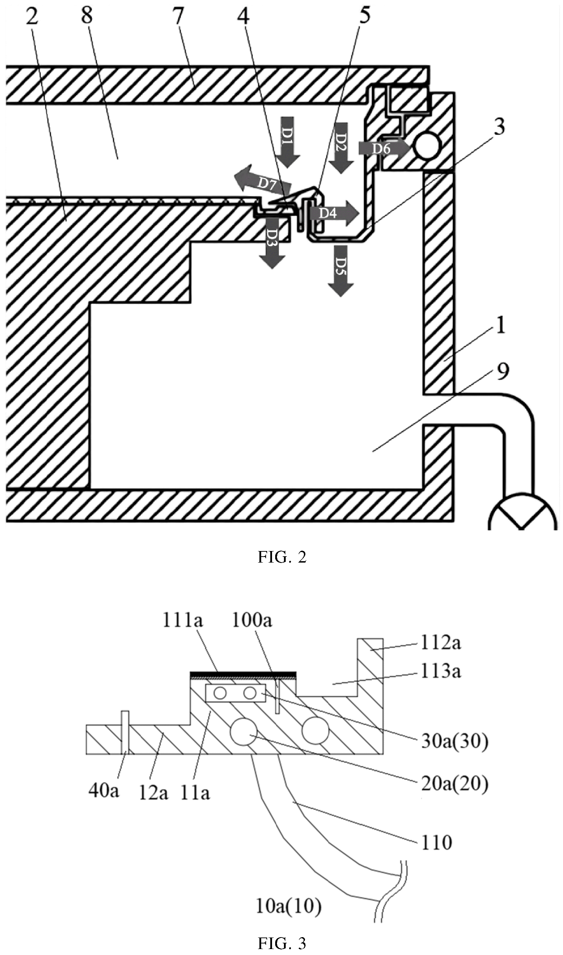

It is found by research that as shown in FIG. 2, a large amount of process heat generated by the plasma during sputtering may be transferred along Direction 1 (D1) and Direction 2 (D2) to the process kit including the liner assembly 3, the deposition ring 4, and the shielding ring 5, causing temperature rise of the liner assembly 3, the shielding ring 5, and the deposition ring 4. Since the deposition ring 4 is located on the outer peripheral side of the carrier 2, the deposition ring 4 has poor heat dissipation efficiency in Direction 3 (D3); since the shielding ring 5 does not contact the liner assembly 3 during the process, the shielding ring 5 also has poor heat transfer efficiency in Direction 4 (D4) shown in FIG. 2; since the non-process area 9 is in a vacuum state, heat transfer efficiency of the liner assembly 3 to the non-process area 9 along Direction 5 (D5) is also poor; since a bottom wall of the liner assembly 3 is farther from a sidewall of the chamber body 1 than a sidewall of the liner assembly 3 is, the liner assembly 3 has poor heat transfer efficiency along Direction 6 (D6). As can be seen, the liner assembly 3, the shielding ring 5, and the deposition ring 4 have poor heat dissipation in all directions, such that an accumulated temperature of the process kit becomes higher and higher, which leads to thermal radiation of the process kit including the liner assembly 3, the deposition ring 4, and the shielding ring 5 to the wafer along Direction 7 (D7), and further causes severe thermal stress defects of wafer film formation. That is, in the high-power (22 KW-55 KW) sputtering process of the aluminum film and other types of films in the related technology, there is the problem of severe thermal stress defects of wafer film formation caused by an insufficient cooling control capability for the process kit including the liner assembly 3, the deposition ring 4, and the shielding ring 5.

Secondly, for a low-power (1 KW-10 KW) metal/metal nitride sputtering process with small film thickness (i.e., short sputtering time), during film formation of those materials, a thermal effect as strong as that of aluminum does not occur, but temperature accumulation is slow due to the low sputtering power and the short sputtering time, and it generally takes a long time for the process kit to reach 200°C in a continuous sputtering process. Therefore, such sputtering process requires rapid heating to reach a process temperature. Moreover, since heat in the process kit is also continuously accumulated during the process, a temperature of the process kit also causes an edge thermal radiation effect on the wafer.

For example, during sputtering of the first few wafers, the process kit including the liner assembly 3, the deposition ring 4, and the shielding ring 5 does not accumulate much heat, resulting in weak edge thermal radiation on the wafer. As the sputtering time continues to increase, the process kit accumulates a large amount of process heat, which gradually enhances the edge thermal radiation on the wafer. Thus, film formation quality of the first few wafers (in the presence of weak thermal radiation of the process kit) is greatly different from that of the following wafers (in the presence of strong thermal radiation of the process kit), causing a first wafer effect and a problem of unstable wafer quality. Moreover, the process kit including the liner assembly 3, the deposition ring 4, and the shielding ring 5 in the related technology is not only poor in cooling control capability, but also lacks a heating control capability, such that the temperature of the process kit changes during the process, and the change of the temperature of the process kit causes a large temperature difference between the first few wafers and the following wafers, causing the significant first wafer effect in terms of film formation quality. That is, the process kit including the liner assembly 3, the deposition ring 4, and the shielding ring 5 in the related technology has both poor cooling performance and poor heating performance, can be only passively heated, and has an uncontrolled temperature.

Thirdly, a purity problem of the chamber body 1 can be easily caused at an initial stage of maintenance and recovery of the target 7 or the process kit, and further causes various defects of wafers during the process. That is because the liner assembly 3, the deposition ring 4, and the shielding ring 5 in the process kit are mostly metal parts, the metal parts are in contact with the atmosphere after the chamber is vented during maintenance, and adsorb a large amount of impurities such as water vapor and oxygen, and the adsorbed impurities if not removed in time after the maintenance and recovery of the chamber may precipitate in a high-temperature environment, and cause film defects under the plasma sputtering; and the more the residual impurities, the more severe the film defects.

In view of the above, in the related technology, a halogen lamp is additionally disposed on a lower sidewall of the chamber after maintenance to perform radiation heating on the liner assembly 3, the shielding ring 5, and the deposition ring 4 for removing the impurities. However, due to limited heating capacity of the halogen lamp, the heating effect on the liner assembly 3, the shielding ring 5, and the deposition ring 4 is not obvious, and the liner assembly 3, the shielding ring 5, and the deposition ring 4 can hardly reach relatively high temperatures, resulting a failure to effectively remove the impurities.

Further, after a nitride film or other types of films are formed on the liner assembly 3, the shielding ring 5, and the deposition ring 4 by sputtering, during idle time (that is, when no direct current sputtering is performed and no plasma heat source is generated), the nitride film may harden and fall off due to temperature drop of the liner assembly 3, the shielding ring 5, and the deposition ring 4, and may disperse in the chamber and even fall on the wafer, causing defects of the wafer.

Finally, the shielding ring 5, the deposition ring 4, and an insulating portion of the carrier 2 are at floating potential during the process. The chamber body 1 is at zero potential, resulting in a large potential difference with a negative potential of the carrier 2. Due to the large potential difference, ignition of the process gas occurs in the non-process area 9, thereby causing film contamination on the chamber body 1.

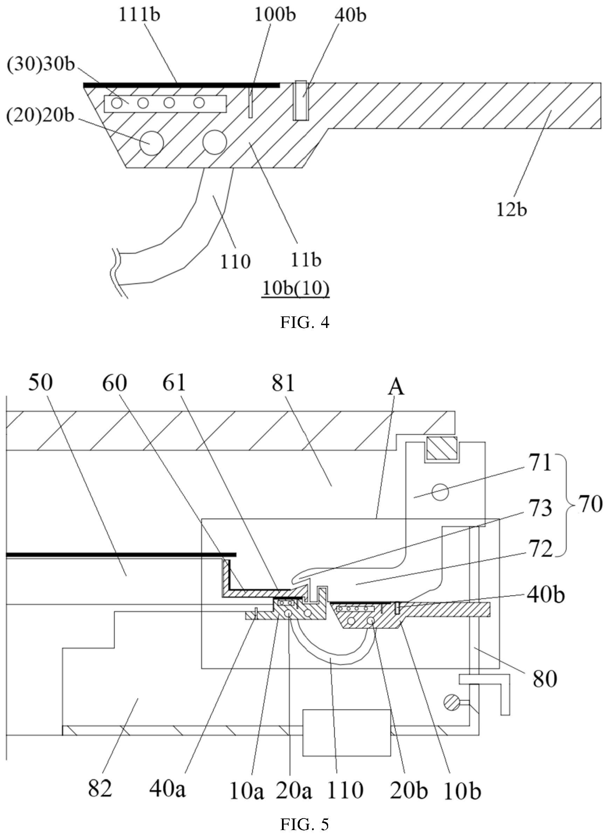

In order to solve the above problems, as shown in FIG. 3 and FIG. 4, the present disclosure discloses an auxiliary temperature-control device for a semiconductor process chamber. The auxiliary temperature-control device includes a heat conduction assembly 10, a cooling channel 20, and a heating assembly 30. The heat conduction assembly 10 is configured to be fixedly connected to the semiconductor process chamber for heat exchange with a process kit in the semiconductor process chamber; and the cooling channel 20 and the heating assembly 30 are both disposed in the heat conduction assembly 10, the cooling channel 20 is configured to introduce a cooling fluid to cool the heat conduction assembly 10, and the cooling fluid includes, for example, a cooling liquid or a cooling gas. The heating assembly 30 is configured to heat the heat conduction assembly 10. The auxiliary temperature-control device can cool or heat the heat conduction assembly 10 with the cooling channel 20 and the heating assembly 30, so that a temperature difference is generated between the heat conduction assembly 10 and the process kit, and the heat exchange with the process kit can be realized, thereby adjusting a temperature of the process kit.

It should be noted that according to the present disclosure, the process kit includes a deposition ring 60 and a liner assembly 70 which are disposed in the semiconductor process chamber, and is configured to cooperate with a carrier 50 which is disposed in the semiconductor process chamber for holding a wafer, so as to divide an interior of the semiconductor process chamber into a process area and a non-process area; and the process area is used for performing a semiconductor process.

When the temperature of the process kit is too high, the cooling fluid may be introduced into the cooling channel 20 to reduce a temperature of the heat conduction assembly 10, so that a temperature difference is generated between the heat conduction assembly 10 and the process kit, heat in the process kit may be transferred to the heat conduction assembly 10, the heat conduction assembly 10 may transfer the heat to the cooling fluid, and the heat may be taken away by the flowing cooling fluid, thereby reducing the temperature of the process kit.

Conversely, when the temperature of the process kit is too low, the heating assembly 30 may be used to heat the heat conduction assembly 10, so that a temperature difference is generated between the heat conduction assembly 10 with an increased temperature and the process kit, and heat in the heat conduction assembly 10 may be transferred to the process kit. As the heating assembly 30 keeps heating the heat conduction assembly 10, the heat in the heat conduction assembly 10 may be continuously transferred to the process kit, thereby increasing the temperature of the process kit.

In the auxiliary temperature-control device provided in the present disclosure, by providing the heat conduction assembly 10 and disposing the cooling channel 20 and the heating assembly 30 in the heat conduction assembly 10, the temperature of the heat conduction assembly 10 can be adjusted with the cooling channel 20 and the heating assembly 30, and heat exchange can be performed between the heat conduction assembly 10 and the process kit to adjust the temperature of the process kit, so that the temperature of the process kit can be prevented from being too high or too low to affect wafers, which can improve wafer product quality.

The auxiliary temperature-control device provided in the present embodiment is illustrated in detail below by an exemplary embodiment. In the present embodiment, the auxiliary temperature-control device is applied to the semiconductor process chamber (e.g., a physical magnetron chamber), and referring to FIG. 5, the semiconductor process chamber includes a chamber body 80 and the carrier 50 disposed in the chamber body 80, and the process kit is disposed in the chamber body 80. The process kit includes the deposition ring 60 and the liner assembly 70, and the auxiliary temperature-control device is configured to adjust a temperature of the deposition ring 60 and that of the liner assembly 70.

Referring to FIG. 5, during a sputtering process in the semiconductor process chamber, the carrier 50 cooperates with the process kit to divide an interior of the chamber body 80 into an upper chamber 81 and a lower chamber 82. It should be understood that the upper chamber 81 is a space for performing a process on a wafer, i.e., a process area. In order to avoid contamination on wafers, the auxiliary temperature-control device is disposed in the lower chamber 82 (i.e., a non-process area).

As shown in FIG. 3, in the present embodiment, the heat conduction assembly 10 includes a first heat conducting member 10a; the cooling channel 20 includes a first cooling channel 20a; and the heating assembly 30 includes a first heating element 30a. The first heat conducting member 10a is configured to be connected to the carrier 50 and to be attached to the deposition ring 60 of the process kit for heat exchange with the deposition ring 60, and the first cooling channel 20a and the first heating element 30a are both disposed in the first heat conducting member 10a. By configuring the first cooling channel 20a and the first heating element 30 to cool or heat the first heat conducting member 10a, a temperature difference is generated between the first heat conducting member 10a and the deposition ring 60, thereby realizing the heat exchange with the deposition ring 60.

During low-power metal thin film sputtering and high-power aluminum sputtering, the temperature of the deposition ring 60 continuously rises along with the process, the deposition ring 60 with the raised temperature may continuously transfer heat to the first heat conducting member 10a, and then the heat is taken away by the cooling fluid in the first cooling channel 20a. In this way, the temperature of the deposition ring 60 is reduced, the heat is effectively prevented from being accumulated on the deposition ring 60, the temperature of the deposition ring 60 is prevented from being too high, and service life of the deposition ring 60 is effectively ensured; meanwhile, reverse thermal radiation by the deposition ring 60 to wafers can be avoided, and process performance of the wafers can be improved. Moreover, a process temperature can be kept relatively stable during the process, the first wafer effect can be avoided, and stability of the wafer product quality can be ensured.

In addition, at an initial stage of the low-power metal thin film sputtering, the deposition ring 60 may be indirectly heated by the first heating element 30a to radiate heat to the wafers, so that a temperature required by the process can be rapidly reached, the first wafer effect can be avoided, and the stability of the wafer product quality can be ensured. During maintenance, the first heating element 30a together with the halogen lamp rapidly heat the deposition ring 60 to increase the temperature thereof, so that impurities adsorbed by the deposition ring 60 can rapidly precipitate, and maintenance and recovery speed and quality of the deposition ring 60 can be improved. Moreover, during idle time, the deposition ring 60 may be continuously heated, so that nitride on the deposition ring 60 can be prevented from hardening and falling off due to a low temperature, which can avoid process defects, enhance particle control capability, and improve the wafer product quality.

As shown in FIG. 3, in the present embodiment, the first heat conducting member 10a includes an annular first heat exchange portion 11a and a first connecting portion 12a. The annular first heat exchange portion 11a has a first heat exchange surface 111a for attachment to the deposition ring 60, the first heat exchange surface 111a may be parallel to a carrying surface (a plane for supporting the wafers) of the carrier 50, a heat conduction layer is disposed on the first heat exchange surface 111a, and the first heat exchange surface 111a is attached to the deposition ring 60 via the heat conduction layer, so as to improve heat transfer efficiency. The first cooling channel 20a and the first heating element 30a are located in the first heat exchange portion 11a, the first cooling channel 20a and the first heating element 30a are both arranged along a circumferential direction of the first heat exchange portion 11a, and the first heating element 30a is located between the first heat exchange surface 111a and the first cooling channel 20a. By disposing the first heating element 30a between the first cooling channel 20a and the first heat exchange surface 111a, the first heating element 30a is closer to the deposition ring 60 when performing heating, so that heat loss during heat transfer can be reduced, and heating efficiency can be improved. In the present embodiment, the first heating element 30a is, for example, a heating wire.

As shown in FIG. 3, the first connecting portion 12a is connected on an inner circumferential side of the first heat exchange portion 11a (a left side of the first heat exchange portion 11a in FIG. 3), and is configured to be connected to the carrier 50. By providing the first connecting portion 12a, the first heat exchange portion 11a is fixedly connected to the carrier 50 with the first connecting portion 12a, so that the first heat exchange surface 111a of the first heat exchange portion 11a is attached to the deposition ring 60. In the present embodiment, an upper surface of the first connecting portion 12a and an inner circumferential surface of the first heat exchange portion 11a form an inner annular groove, and an outer peripheral wall of the carrier 50 is located in the inner annular groove.

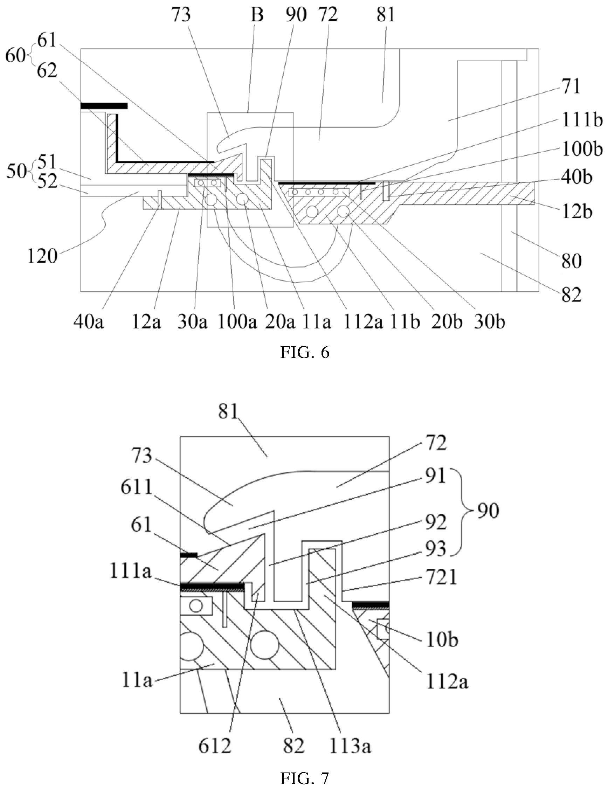

As shown in FIG. 3, the first heat exchange portion 11a is further provided with a first annular protrusion 112a and a first annular groove 113a, the first annular protrusion 112a is located on an outer circumferential side of the first heat exchange surface 111a (a right side of the first heat exchange surface 111a in FIG. 3), the first annular groove 113a is located between the first heat exchange surface 111a and the first annular protrusion 112a, and the first annular protrusion 112a and the first annular groove 113a are used for clearance fit with the liner assembly 70 to form a labyrinth passage 90 (see FIG. 6). By providing the first annular protrusion 112a and the first annular groove 113a and configuring the first annular protrusion 112a and the first annular groove 113a to be in clearance fit with the liner assembly 70 to form the labyrinth passage 90, contamination on the lower chamber 82 caused by diffusion and leakage of plasma from the upper chamber 81 to the lower chamber 82 through a gap between the first annular groove 113a and the liner assembly 70 during a sputtering process can be avoided.

In some embodiments, as shown in FIG. 4, the heat conduction assembly 10 further includes a second heat conducting member 10b; the cooling channel 20 further includes a second cooling channel 20b; and the heating assembly 30 further includes a second heating element 30b. The second heat conducting member 10b is configured to be connected to an inner wall of the chamber body 80 and to be attached to the liner assembly 70 for heat exchange with the liner assembly 70, and the second cooling channel 20b and the second heating element 30b are both disposed in the second heat conducting member 10b. By configuring the second cooling channel 20b and the second heating element 30b to cool or heat the second heat conducting member 10b, a temperature difference is generated between the second heat conducting member 10b and the liner assembly 70, thereby realizing the heat exchange with the liner assembly 70.

During low-power metal thin film sputtering and high-power aluminum sputtering, the temperature of the liner assembly 70 continuously rises along with the process, the liner assembly 70 with the raised temperature may continuously transfer heat to the second heat conducting member 10b, and then the heat is taken away by the cooling fluid in the second cooling channel 20b. In this way, the temperature of the liner assembly 70 is reduced, the heat is effectively prevented from being accumulated on the liner assembly 70, the temperature of the liner assembly 70 is prevented from being too high, and service life of the liner assembly 70 is effectively ensured; meanwhile, reverse thermal radiation by the liner assembly 70 to the wafers can be avoided, and the process performance of the wafers can be improved. Moreover, a process temperature can be kept relatively stable during the process, the first wafer effect can be avoided, and the stability of the wafer product quality can be ensured.

In addition, at the initial stage of the low-power metal thin film sputtering, the liner assembly 70 may be indirectly heated by the second heating element 30b to radiate heat to the wafers, so that a temperature required by the process can be rapidly reached, the first wafer effect can be avoided, and the stability of the wafer product quality can be ensured. During maintenance, the second heating element 30b together with the halogen lamp rapidly heat the liner assembly 70 to increase the temperature thereof, so that impurities adsorbed by the liner assembly 70 can rapidly precipitate, and maintenance and recovery speed and quality of the liner assembly 70 can be improved. Moreover, during idle time, the liner assembly 70 may be continuously heated, so that nitride on the liner assembly 70 can be prevented from hardening and falling off due to a low temperature, which can avoid the process defects, enhance the particle control capability, and improve the wafer product quality.

As shown in FIG. 4, the second heat conducting member 10b is provided with an annular second heat exchange portion 11b and a second connecting portion 12b, the second heat exchange portion 11b has a second heat exchange surface 111b for attachment to the liner assembly 70, the second heat exchange surface 111b is parallel to a bonding surface of the liner assembly 70, a heat conduction layer is also disposed on the second heat exchange surface 111b, and the second heat exchange surface 111b is attached to the liner assembly 70 via the heat conduction layer, so as to improve heat transfer efficiency. The second cooling channel 20b and the second heating element 30b are located in the second heat exchange portion 11b, and are both arranged along a circumferential direction, and the second heating element 30b is located between the second heat exchange surface 111b and the second cooling channel 20b. Similarly, by disposing the second heating element 30b between the second cooling channel 20b and the second heat exchange surface 111b, the second heating element 30b is closer to the liner assembly 70 when performing heating, so that heat loss during heat transfer can be reduced, and heating effects can be improved. In the present embodiment, the second heating element 30b is, for example, a heating wire.

The second connecting portion 12b is connected on an outer circumferential side (a right side in FIG. 4) of the second heat exchange portion 11b, and is configured to be connected to the inner wall of the chamber body 80. Referring to FIG. 6, the second connecting portion 12b penetrates the inner wall of the chamber body 80 and is fixedly connected to the inner wall of the chamber body 80, so as to attach the second heat exchange surface 111b to the liner assembly 70. Meanwhile, the second connecting portion 12b is hermetically connected to the inner wall of the chamber body 80, so as to ensure a vacuum state inside the chamber body 80.

It should be noted that as can be seen from FIG. 6, part of the second connecting portion 12b already extends out of the chamber body 80. The part of the second connecting portion 12b which is located outside the chamber body 80 may be grounded, so that the entire second heat conducting member 10b is at zero potential. Since the chamber body 80 is in direct contact with the second connecting portion 12b, the inner wall of the chamber body 80 may also be at zero potential, so that ignition in the lower chamber 82 caused by a large potential difference between the second heat conducting member 10b and the inner wall of the chamber body 80 can be avoided.

In the present embodiment, the auxiliary temperature-control device further includes a first conductive member 40a and a second conductive member 40b. The first conductive member 40a is respectively electrically connected to the first heat conducting member 10a and the carrier 50, and the second conductive member 40b is respectively electrically connected to the second heat conducting member 10b and the liner assembly 70.

Exemplarily, as shown in FIG. 3, a first end of the first conductive member 40a is connected to the first connecting portion 12a, and a second end of the first conductive member 40a protrudes from the upper surface of the first connecting portion 12a. Referring to FIG. 5, during assembly, the second end of the first conductive member 40a is fixedly connected to the carrier 50, so that the carrier 50 is fixedly connected to the first heat conducting member 10a through the first conductive member 40a; meanwhile, since the first conductive member 40a is made of metal, the first conductive member 40a may enable electrical conduction between the first heat conducting member 10a and the carrier 50.

In the auxiliary temperature-control device provided in the present disclosure, by providing the first conductive member 40a and fixing and electrically connecting the first heat conducting member 10a to the carrier 50 through the first conductive member 40a, the first conductive member 40a and the carrier 50 are equal in potential on the basis of ensuring stability of the attachment of the first heat conducting member 10a to the deposition ring 60; and the first conductive member 40a is also at zero potential after the carrier 50 is grounded. In this way, a relatively large potential difference can be prevented from being generated between the first heat conducting member 10a and the carrier 50 or the inner wall of the chamber body 80, the ignition in the lower chamber 82 can be effectively avoided, film contamination on the lower chamber 82 can be prevented, and equipment stability can be improved.

It should be understood that in order to improve connection reliability, the first conductive member 40a may be a silver-plated bolt in the present embodiment. The first heat conducting member 10a is fixed and electrically connected to the carrier 50 with the silver-plated bolt, thereby improving reliability of the connection between the first heat conducting member 10a and the carrier 50. Certainly, the present disclosure is not limited thereto, and any component capable of simultaneously performing a fixing function and an electrical connection function is within the scope of the present disclosure.

As shown in FIG. 4, the second heat exchange surface 111b is provided with a mounting groove, and a first end of the second conductive member 40b is located in the mounting groove and fixedly connected to an inner wall of the mounting groove. A second end of the second conductive member 40b protrudes from the second heat exchange surface 111b. Referring to FIG. 6, when the second heat exchange surface 111b is attached to the liner assembly 70, the second end of the second conductive member 40b abuts against a surface of the liner assembly 70, and electrical conduction between the second conductive member 40b and the liner assembly 70 is realized because the second conductive member 40b is made of metal. Since electrical conduction is also realized between the second heat conducting member 10b and the inner wall of the chamber body 80 after the second heat conducting member 10b is connected to the inner wall of the chamber body 80, electrical conduction of the second heat conducting member 10b, the interior of the chamber body 80, and the liner assembly 70 is realized.

In the auxiliary temperature-control device provided in the present disclosure, by providing the second conductive member 40b and electrically connecting the second heat conducting member 10b to the liner assembly 70 through the second conductive member 40b, the second conductive member 40b, the inner wall of the chamber body 80, and the liner assembly 70 are equal in potential, and the second conductive member 40b, the inner wall of the chamber body 80, and the liner assembly 70 are all at zero potential after the second heat conducting member 10b is grounded. In this way, a relatively large potential difference is effectively prevented from being generated between the second conductive member 40b and the liner assembly 70 or the inner wall of the chamber body 80, the ignition in the lower chamber 82 can be avoided, film contamination on the lower chamber 82 can be prevented, and the equipment stability can be improved. The zero potential and equipotential state is immune from plasma bombardment and radio frequency leakage.

It should be understood that the second end of the second conductive member 40b is just slightly higher than the second heat exchange surface 111b, so as not to affect the attachment between the second heat exchange surface 111b and the liner assembly 70; in addition, the second heat exchange surface 111b needs to avoid the second conductive member 40b, so as not to affect the electrical conduction between the second conductive member 40b and the liner assembly 70.

In the embodiment illustrated by FIG. 6, a connecting wire (not shown) is further disposed between the first heat conducting member 10a and the second heat conducting member 10b, and two ends of the connecting wire are connected to the first heat conducting member 10a and the second heat conducting member 10b respectively, so as to achieve electrical conduction between the first heat conducting member 10a and the second heat conducting member 10b. After the electrical conduction between the first heat conducting member 10a and the second heat conducting member 10b is achieved, the carrier 50, the first heat conducting member 10a, the second heat conducting member 10b, the liner assembly 70, and the inner wall of the chamber body 80 are all at equal potential. After the second heat conducting member 10b is grounded, the carrier 50, the first heat conducting member 10a, the second heat conducting member 10b, the liner assembly 70, and the inner wall of the chamber body 80 which are located in the lower chamber 82 are all at zero potential, which effectively avoids the ignition in the lower chamber 82. Thus, the lower chamber 82 is immune from plasma bombardment and radio frequency leakage, the film contamination on the lower chamber 82 is avoided, and equipment stability and lifespan are improved.

As shown in FIG. 5, in the present embodiment, a coolant pipe 110 is further disposed between the first heat conducting member 10a and the second heat conducting member 10b, one end of the coolant pipe 110 communicates with the first cooling channel 20a, and a second end of the coolant pipe 110 communicates with the second cooling channel 20b, so that the first cooling channel 20a and the second cooling channel 20b communicate with each other and may share a water inlet pipeline and a water outlet pipeline (not shown). Similarly, the first heating element 30a and the second heating element 30b may be electrically connected to each other through a wire (not shown), so that the first heating element 30a and the second heating element 30b may share a set of circuits for power supply and control. In this way, overall structure can be simplified, the risk of gas leakage inside the chamber body 80 can be reduced, and modification cost can also be reduced.

In the present embodiment, the auxiliary temperature-control device further includes a temperature measurement assembly, which includes, for example, a first temperature measuring member 100a and a second temperature measuring member 100b. The first temperature measuring member 100a is disposed on the first heat conducting member 10a for detecting the temperature of the deposition ring 60, and the second temperature measuring member 100b is disposed on the second heat conducting member 10b for detecting the temperature of the liner assembly 70.

As shown in FIG. 3, the first temperature measuring member 100a is embedded in the first heat exchange portion 11a of the first heat conducting member 10a, one end of the first temperature measuring member 100a extends to the first heat exchange surface 111a, and the heat conduction layer on the first heat exchange surface 111a covers the first temperature measuring member 100a. When the first heat exchange surface 111a is attached to the deposition ring 60, the first temperature measuring member 100a may also abut against the deposition ring 60 via the heat conduction layer to measure the temperature of the deposition ring 60. Since the heat conduction layer covers the first temperature measuring member 100a, that is, the heat conduction layer conducts heat between the first temperature measuring member 100a and the deposition ring 60, the first temperature measuring member 100a can detect a temperature accurately and timely.

Similarly, as shown in FIG. 4, the second temperature measuring member 100b is embedded in the second heat exchange portion 11b of the second heat conducting member 10b, one end of the second temperature measuring member 100b extends to the second heat exchange surface 111b, and the heat conduction layer on the second heat exchange surface 111b covers the second temperature measuring member 100b. When the second heat exchange surface 111b is attached to the liner assembly 70, the second temperature measuring member 100b may also abut against the liner assembly 70 via the heat conduction layer to measure the temperature of the liner assembly 70. Since the heat conduction layer covers the second temperature measuring member 100b, that is, the heat conduction layer conducts heat between the second temperature measuring member 100b and the liner assembly 70, the second temperature measuring member 100b can detect a temperature accurately and timely.

In the auxiliary temperature-control device provided in the present disclosure, by providing the temperature measurement assembly, the temperatures of the deposition ring 60 and the liner assembly 70 can be monitored and fed back in real time, so that the temperatures of the deposition ring 60 and the liner assembly 70 can be actively adjusted based on the feedback of the temperatures, thereby realizing closed-loop temperature regulation. In this way, the process temperature is within an optimal temperature range, fluctuation of the process temperature is reduced, the first wafer effect is avoided, and the stability of the wafer product quality is ensured. In the present embodiment, both the first temperature measuring member 100a and the second temperature measuring member 100b are temperature measuring thermocouples, but the present disclosure is not limited thereto, and on the premise of not departing from the operating principle and the inventive concept of the present disclosure, any device capable of measuring temperature is within the scope of the present disclosure.

In a second aspect of the present disclosure, there is further provided a semiconductor process chamber, including: a chamber body 80, a carrier 50, a process kit, and the above auxiliary temperature-control device.

In the embodiment illustrated by FIG. 5, the carrier 50 and the process kit are both disposed in the chamber body 80. The auxiliary temperature-control device is fixedly connected to at least one of the chamber body 80 or the carrier 50 for adjusting a temperature of the process kit.

In the semiconductor process chamber provided in the present disclosure, by providing the auxiliary temperature-control device, the temperature of process kit can be adjusted with the auxiliary temperature-control device, so that the temperature of the process kit can be prevented from being too high or too low to affect wafer quality, which can improve wafer product quality.

It should be understood that in the present embodiment, the carrier 50 is liftably disposed in the chamber body 80, and the carrier 50 may be lifted or lowered to engage with or disengage from a liner assembly 70. Referring to FIG. 5, during a sputtering process in the semiconductor process chamber, the carrier 50 is lifted to a position for engaging with the liner assembly 70, the carrier 50 and the liner assembly 70 divide an interior of the chamber body 80 into an upper chamber 81 and a lower chamber 82, the upper chamber 81 is a process area for performing a sputtering process on a wafer, the lower chamber 82 is a non-process area, and the auxiliary temperature-control device is disposed in the lower chamber 82.

Referring to FIG. 5, the process kit includes the liner assembly 70 and a deposition ring 60, the liner assembly 70 is connected to the chamber body 80, the deposition ring 60 is disposed around the carrier 50, and the deposition ring 60 is in clearance fit with the liner assembly 70 after the carrier 50 is lifted to the position for engaging with the liner assembly 70. The auxiliary temperature-control device includes a first heat conducting member 10a and a second heat conducting member 10b, the first heat conducting member 10a is connected to the carrier 50, and is attached to the deposition ring 60; and the second heat conducting member 10b is connected to an inner wall of the chamber body 80, and is attached to the liner assembly 70.

Exemplarily, as shown in FIG. 6, the deposition ring 60 is provided with an annular fitting portion 61 at an outer circumferential side thereof, and the fitting portion 61 extends outwards to an outer side of the carrier 50, and the first heat conducting member 10a is attached to the fitting portion 61. For example, the deposition ring 60 includes a main body 62 and the fitting portion 61 disposed on an outer circumferential side of the main body 62, and the fitting portion 61 is an annular structure. The fitting portion 61 extends to the outer side of the carrier 50 along a direction parallel to a carrying surface, and is located between the carrier 50 and the liner assembly 70, and the fitting portion 61 has a first side facing the carrying surface and a second side away from the carrying surface.

As shown in FIG. 7, the fitting portion 61 has an annular inclined surface 611 on the first side thereof, and a height of the annular inclined surface 611 gradually increases in a direction from the inside to the outside (from left to right in FIG. 7) of the deposition ring 60. A second annular protrusion 612 is disposed on the second side of the fitting portion 61, and is located on an outer circumferential side of the fitting portion 61, and the first heat conducting member 10a is attached on the second side of the fitting portion 61.

In some embodiments, as shown in FIG. 6, the liner assembly 70 includes a sidewall portion 71 and a bottom wall portion 72. The sidewall portion 71 is disposed along a direction perpendicular to the carrying surface of the carrier 50; and the bottom wall portion 72 is connected to the sidewall portion 71, is disposed along the direction parallel to the carrying surface, and is, for example, an annular structure, an inner peripheral wall of the bottom wall portion 72 is in clearance fit with an outer side of the fitting portion 61, an outer part of the bottom wall portion 72 is connected to the sidewall portion 71, and the second heat conducting member 10b is attached to the bottom wall portion 72.

In some embodiments, as shown in FIG. 7, the liner assembly 70 further includes a shielding portion 73, which is an annular structure and is connected to the inner peripheral wall of the bottom wall portion 72. The shielding portion 73 is located above the annular inclined surface 611, an inner surface of the shielding portion 73 facing the annular inclined surface 611 is parallel to the annular inclined surface 611, and a first passage 91 is formed between the inner surface of the shielding portion 73 and the annular inclined surface 611. The inner peripheral wall of the bottom wall portion 72 is parallel to an outer peripheral wall of the fitting portion 61, and a second passage 92 communicating with the first passage 91 is formed between the inner peripheral wall of the bottom wall portion 72 and the outer peripheral wall of the fitting portion 61. The first passage 91 and the second passage 92 communicating with each other form a part of a labyrinth passage 90 together.

As shown in FIG. 6, the first heat conducting member 10a includes an annular first heat exchange portion 11a and a first connecting portion 12a. As shown in FIG. 7, a first heat exchange surface 111a of the first heat exchange portion 11a is attached to the second side of the fitting portion 61. The first heat exchange portion 11a is further provided with a first annular protrusion 112a and a first annular groove 113a, the first annular protrusion 112a is located on an outer peripheral side of the first heat exchange surface 111a (a right side of the first heat exchange surface 111a in FIG. 7), the first annular groove 113a is located between the first heat exchange surface 111a and the first annular protrusion 112a, and the second annular protrusion 612 is located in the first annular groove 113a.

As shown in FIG. 7, the bottom wall portion 72 is provided with a second annular groove 721, and after the carrier 50 is lifted to the position for engaging with the liner assembly 70, the first annular protrusion 112a is inserted into the second annular groove 721 for clearance fit with the second annular groove 721, so that a third passage 93 communicating with the second passage 92 is formed between an outer wall of the first annular protrusion 112a and an inner wall of the second annular groove 721 and between the bottom wall portion 72 and an inner wall of the first annular groove 113a.

As shown in FIG. 7, the first passage 91, the second passage 92, and the third passage 93, which communicate with each other, form the labyrinth passage 90 together, and the upper chamber 81 communicates with the lower chamber 82 through the labyrinth passage 90. During a sputtering process, since the first passage 91 directly communicates with the upper chamber 81 and is totally oblique, a small amount of thin film is formed by plasma in the first passage 91; since the second passage 92 communicates with the upper chamber 81 through the first passage 91, a trace of thin film is formed by the plasma in the second passage 92; since the third passage 93 communicates with the upper chamber 81 through the first passage 91 and the second passage 92, the plasma is basically used up in the first passage 91 and the second passage 92, so that no thin film is formed in the third passage 93. Thus, the plasma is effectively prevented from continuously leaking downwards and being sputtered to the lower chamber 82, the risk of ignition is avoided, and film contamination on the lower chamber 82 is prevented; meanwhile, an ignition gas (generally argon) can be guided into the upper chamber 81 through the labyrinth passage 90 to be effectively ignited. In addition, a labyrinth passage structure in the existing technology is mostly formed by the deposition ring 60 and the liner assembly 70, which results in large cleaning area of the deposition ring 60. The present disclosure proposes effective splitting of the labyrinth passage; compared with the labyrinth passage structure in the existing technology, the third passage 93 with no thin film formed thereon does not need to be cleaned, so that the cleaning area of the deposition ring 60 can be effectively reduced, cleaning cost can be saved, cleaning risk and probability of cleaning defects can be reduced, and scrap risk caused by cleaning can also be reduced.

As shown in FIG. 6, an outer peripheral wall of the carrier 50 and a surface at the second side of the fitting portion 61 form an annular step structure 120, an upper surface of the first connecting portion 12a and an inner circumferential surface of the first heat exchange portion 11a form an inner annular groove, part of the annular step structure 120 is located in the inner annular groove, and the first connecting portion 12a and the annular step structure 120 are fixed and electrically connected to each other with a first conductive member 40a, so as to ensure attachment of the first heat exchange surface 111a and the deposition ring 60.

It should be understood that as shown in FIG. 6, the carrier 50 includes a ceramic portion 51 for carrying a wafer and a metal portion 52 under the ceramic portion 51, the ceramic portion 51 and the metal portion 52 are connected at the annular step structure 120, that is, part of the annular step structure 120 close to the deposition ring 60 is the ceramic portion 51, part of the annular step structure 120 away from the deposition ring 60 is the metal portion 52, and the first conductive member 40a is connected to the metal portion 52, thereby achieving reliable and stable fixing and electrical connection.

An operating principle of the semiconductor process chamber according to the embodiments of the present disclosure is described below in conjunction with specific process conditions.

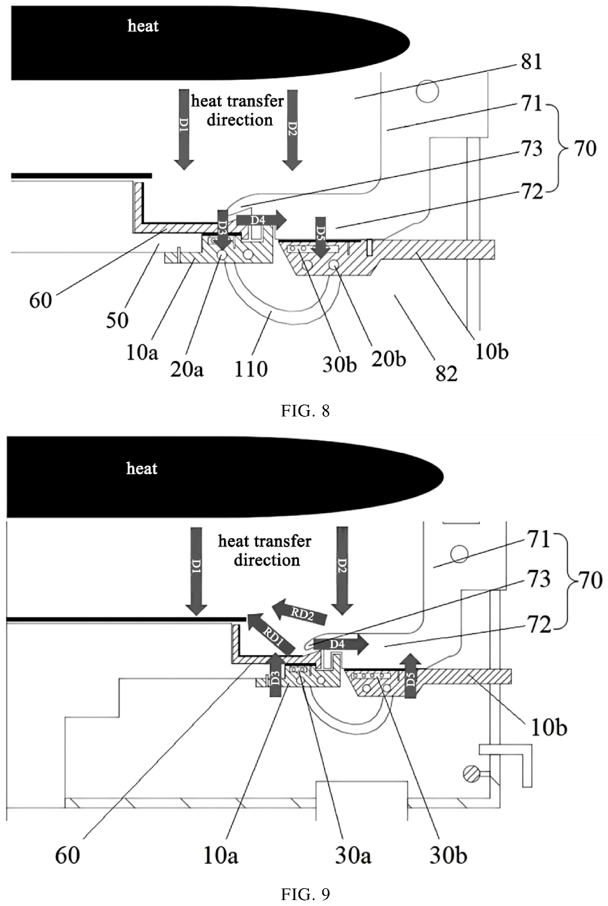

During a high-power aluminum sputtering process, energy of the plasma increases with power increase, the higher the power, the more the energy, the more the generated heat. As shown in FIG. 8, heat generated by the plasma is transferred to the deposition ring 60 along Direction 1 and is transferred to the liner assembly 70 along Direction 2.

After the deposition ring 60 is heated, the heat continues to be transferred, part of the heat in the deposition ring 60 is transferred downwards to the first heat conducting member 10a along Direction 3, and the remaining part of the heat in the deposition ring 60 is transferred to the bottom wall portion 72 of the liner assembly 70 along Direction 4.

After the liner assembly 70 is heated, part of the heat in the bottom wall portion 72 is transferred to the second heat conducting member 10b in the lower chamber 82 along Direction 5.

In the related technology, due to the poor heat transfer efficiency in Direction 3 and that in Direction 5, a large amount of heat is accumulated in the deposition ring 60, the shielding portion 73, and the bottom wall portion 72. In the present disclosure, since the first heat conducting member 10a is attached to the deposition ring 60 and the second heat conducting member 10b is attached to the bottom wall portion 72, the heat transfer efficiency in Direction 3 and that in in Direction 5 can be improved. In addition, with the configuration of the first cooling channel 20a and the second cooling channel 20b, the heat can be taken away by the cooling fluid in the first cooling channel 20a and the second cooling channel 20b, so that the deposition ring 60, the bottom wall portion 72, and the shielding portion 73 can be always kept at relatively low temperatures, which prevents the temperature of the process kit including the deposition ring 60 and the liner assembly 70 from being too high, and prolongs service life of the process kit; meanwhile, reverse heat radiation by the process kit to wafers is prevented, and process performance of the wafers is improved.

As shown in FIG. 9, during a titanium or tantalum sputtering process, since the temperatures of the deposition ring 60 and the liner assembly 70 are insufficient (not reaching an optimal process temperature range) due to low direct current sputtering power at an initial stage of the process, the heat transfer in Directions 1, 2, 4 is slow, and the temperatures of the deposition ring 60, the shielding portion 73, and the bottom wall portion 72 cannot rise to desired optimal process temperatures. Therefore, as shown in FIG. 9, the deposition ring 60 transfers a small amount of heat along Reverse Direction 1 (RD1) and Reverse Direction 2 (RD2), and the shielding portion 73 and the bottom wall portion 72 also transfer a small amount of heat along Reverse Direction 1 and Reverse Direction 2.

In the semiconductor process chamber according to the present disclosure, the deposition ring 60 and the liner assembly 70 can be actively heated by the first heating element 30a and the second heating member 30b respectively, the first heat conducting member 10a transfers heat along Direction 3, and the second heat conducting member 10b transfers heat along Direction 5, so that the deposition ring 60 and the liner assembly 70 can rapidly reach the desired process temperatures, so as to heat the wafers along Reverse Direction 1 and Reverse Direction 2.

It is apparent that the deposition ring 60 and the liner assembly 70 can also be heated by the first heating element 30a and the second heating member 30b during idle time to be kept at certain temperatures, so as to avoid the first wafer effect and the risk of film detachment.

In addition, during maintenance of the process kit, the deposition ring 60 and the liner assembly 70 are subjected to maintenance bake through full power output of the first heating element 30a and the second heating element 30b, and the deposition ring 60 and the liner assembly 70 rapidly reach the highest temperatures for repelling the impurities adsorbed therein, thereby removing the impurities rapidly and thoroughly. Moreover, baking temperatures of the deposition ring 60 and the liner assembly 70 may be measured and evaluated with a first temperature measuring member 100a and a second temperature measuring member 100b, so as to evaluate baking and impurity removal effects.

It should be further noted that in the present embodiment, the heat conduction assembly 10 includes the first heat conducting member 10a and the second heat conducting member 10b, but the present disclosure is not limited thereto. In some other embodiments not illustrated by the drawings, another auxiliary temperature-control device is further disclosed, and has a structure substantially the same as that of the auxiliary temperature-control device provided in the above embodiments. The only difference lies in that the heat conduction assembly 10 includes only one of the first heat conducting member 10a and the second heat conducting member 10b in those other embodiments; accordingly, only the deposition ring 60 is provided with the first heat conducting member 10a or only the liner assembly 70 is provided with the second heat conducting member 10b in the semiconductor process chamber. Such configuration can also realize temperature adjustment of the deposition ring 60 or the liner assembly 70. Therefore, those other embodiments are also within the scope of the present disclosure without departing from the operating principle and the inventive concept of the present disclosure.

It should be understood that the above implementations are just exemplary implementations adopted to illustrate the principle of the present disclosure, and the present disclosure is not limited thereto. Various modifications and improvements can be made by those of ordinary sill in the art without departing from the spirit and essence of the present disclosure, and these modifications and improvements are considered to fall within the scope of the present disclosure.

## Claims

1. An auxiliary temperature-control device for a semiconductor process chamber, comprising:
a heat conduction assembly, which is configured to be fixedly connected to the semiconductor process chamber for heat exchange with a process kit in the semiconductor process chamber;
a cooling channel, which is disposed in the heat conduction assembly, and is configured to introduce a cooling fluid to cool the heat conduction assembly; and
a heating assembly, which is disposed in the heat conduction assembly, and is configured to heat the heat conduction assembly.

2. The auxiliary temperature-control device of claim 1, wherein the heat conduction assembly comprises:
a first heat conducting member, which is configured to be connected to a carrier of the semiconductor process chamber for heat exchange with a deposition ring of the process kit;
the cooling channel comprises:
a first cooling channel, which is disposed in the first heat conducting member; and
the heating assembly comprises:
a first heating element, which is disposed in the first heat conducting member.

3. The auxiliary temperature-control device of claim 1 or 2, wherein the heat conduction assembly comprises:
a second heat conducting member, which is configured to be connected to an inner wall of a chamber body of the semiconductor process chamber for heat exchange with a liner assembly of the process kit;
the cooling channel comprises:
a second cooling channel, which is disposed in the second heat conducting member; and
the heating assembly comprises:
a second heating element, which is disposed in the second heat conducting member.

4. The auxiliary temperature-control device of claim 2, wherein the first heat conducting member comprises:
a first heat exchange portion, which has a first heat exchange surface for attachment to the deposition ring; and
a first connecting portion, which is connected on an inner circumferential side of the first heat exchange portion, and is configured to be connected to the carrier.

5. The auxiliary temperature-control device of claim 4, wherein
the first heat exchange portion is provided with a first annular protrusion and a first annular groove, the first annular protrusion is located on an outer circumferential side of the first heat exchange surface, the first annular groove is located between the first heat exchange surface and the first annular protrusion, and the first annular protrusion and the first annular groove are used for clearance fit with a liner assembly of the semiconductor process chamber to form a labyrinth passage.

6. The auxiliary temperature-control device of claim 3, wherein
the second heat conducting member is provided with a second heat exchange portion and a second connecting portion, the second heat exchange portion has a second heat exchange surface for attachment to the liner assembly, and the second connecting portion is connected on an outer circumferential side of the second heat exchange portion, and is configured to be connected to the inner wall of the chamber body.

7. The auxiliary temperature-control device of claim 2, further comprising:
a first conductive member, which is configured to be respectively electrically connected to the first heat conducting member and the carrier.

8. The auxiliary temperature-control device of claim 3, further comprising:
a second conductive member, which is configured to be respectively electrically connected to the second heat conducting member and the liner assembly.

9. The auxiliary temperature-control device of claim 8, further comprising a connecting wire,
wherein the connecting wire is respectively electrically connected to the first heat conducting member and the second heat conducting member, and the second heat conducting member is further configured to be electrically connected to the inner wall of the chamber body to enable electrical conduction of the carrier, the first heat conducting member, the second heat conducting member, the liner assembly, and the inner wall of the chamber body.

10. The auxiliary temperature-control device of claim 1, further comprising:
a temperature measurement assembly, which is disposed on the heat conduction assembly to detect a temperature of the process kit.

11. A semiconductor process chamber, comprising:
a chamber body;
a carrier and a process kit, which are disposed in the chamber body; and
the auxiliary temperature-control device of any one of claims 1 to 10, the auxiliary temperature-control device being fixedly connected to at least one of the chamber body and/or the carrier to adjust a temperature of the process kit.

12. The semiconductor process chamber of claim 11, wherein the process kit comprises a liner assembly and a deposition ring, the liner assembly being connected to the chamber body, and the deposition ring being disposed around the carrier; and
the auxiliary temperature-control device comprises a first heat conducting member and/or a second heat conducting member, and the first heat conducting member is connected to the carrier, and is attached to the deposition ring; and the second heat conducting member is connected to an inner wall of the chamber body, and is attached to the liner assembly.

13. The semiconductor process chamber of claim 12, wherein
the deposition ring is provided with a fitting portion at an outer circumferential side of the deposition ring, the fitting portion extends outwards to an outer side of the carrier, and the first heat conducting member is attached to the fitting portion.

14. The semiconductor process chamber of claim 12, wherein the liner assembly comprises:
a sidewall portion, which is disposed along a direction perpendicular to a carrying surface of the carrier; and
a bottom wall portion, which is connected to the sidewall portion, the second heat conducting member being attached to the bottom wall portion.

15. The semiconductor process chamber of claim 14, wherein the deposition ring is provided with a fitting portion at an outer circumferential side of the deposition ring, the fitting portion extends outwards to an outer side of the carrier, and the fitting portion has a first side facing the carrying surface and a second side away from the carrying surface; and
the fitting portion has an annular inclined surface on the first side of the fitting portion, and a height of the annular inclined surface gradually increases in a direction from the inside to the outside of the deposition ring; and
the liner assembly further comprises:
a shielding portion, which is connected to an inner peripheral wall of the bottom wall portion, and is located above the annular inclined surface.

16. The semiconductor process chamber of claim 15, wherein a first passage is formed between an inner surface of the shielding portion facing the annular inclined surface and the annular inclined surface; a second passage communicating with the first passage is formed between the inner peripheral wall of the bottom wall portion and an outer peripheral wall of the fitting portion; and the first passage and the second passage form a part of a labyrinth passage together.
